# EUROPÄISCHE PATENTSCHRIFT

(11) **EP 4 133 250 B1**
(45) Veröffentlichungstag und Bekanntmachung des Hinweises auf die Patenterteilung: **14.06.2023**
(21) Anmeldenummer: 21714620.8
(22) Anmeldetag: 25.03.2021
(51) Int. Cl.: G01M 15/02, G01M 13/00

(54) **MESS- UND PRÜFEINRICHTUNG FÜR SCHNELLDREHENDE ELEKTRISCHE MASCHINEN**
MEASURING AND TESTING DEVICE FOR RAPIDLY ROTATING ELECTRIC MACHINES
DISPOSITIF DE MESURE ET DE TEST POUR MACHINES ÉLECTRIQUES À ROTATION RAPIDE

(30) Priorität: 07.04.2020 AT 502972020
(43) Veröffentlichungstag der Anmeldung: 15.02.2023
(73) Patentinhaber: Tectos GmbH, 8054 Graz (AT)
(72) Erfinder: HÖFLER, Dieter, 8020 GRAZ (AT)
(74) Vertreter: Babeluk, Michael
(86) Internationale Anmeldenummer: PCT/AT2021/060101
(87) Internationale Veröffentlichungsnummer: WO 2021/203151

(56) Entgegenhaltungen:
- EP-A1- 3 242 055
- CN-A- 108 303 261
- US-A1- 2002 112 546

## Beschreibung

Die Erfindung betrifft eine Mess- und Prüfeinrichtung für schnelldrehende elektrische Maschinen, mit einem Zwischenrahmen und zumindest einem Lagerbock für eine Zwischenlagerwelle, welche mit zumindest einer schnelldrehenden elektrischen Maschine antriebsverbindbar ist, wobei der Lagerbock vom Zwischenrahmen galvanisch getrennt ist.

Mess- und Prüfeinrichtungen für elektrische Maschinen sind beispielsweise aus CN 201218836 Y, CN 2914104 Y, CN 102621495 A, CN 104569810 A, EP 3 190 397 B1, CN 104635157 A, CN 104950255 A oder CN 106248382 A bekannt.

Die US 2002/0112546 A1 offenbart ein Hochgeschwindigkeits-Rotationsprüfgerät mit einer über einen Elektromotor angetriebenen schwingfähigen Spindel, über welche an ihrem unteren Ende ein Testobjekt gehalten wird. Die Rotorwelle des Elektromotors ist in einem Gehäuse drehbar in vertikaler Richtung gelagert. Zur Dämpfung der Schwingung der Spindel innerhalb des Gehäuses ist ein Dämpfungsmechanismus vorgesehen.

Die DE 10 2010 002 296 A1 offenbart einen Prüfstand für ein Wälzlager mit einer elektrischen Maschine und einem Lagerbock für eine Zwischenlagerwelle, wobei der Lagerbock vom Grundgehäuse über ein Zwischenelement aus elektrisch isolierendem Material galvanisch getrennt ist.

Die CN 107 246 948 A offenbart einen Prüfstand zur Erfassung der charakteristischen Motorschwingungsfrequenz, mit einer elektrischen Maschine und einer mit der elektrischen Maschine verbundenen Welle, welche über Luftlager auf einem Befestigungsrahmen gelagert ist. Die elektrische Maschine ist über Schwingungsisolatoren auf dem Befestigungsrahmen aufgebockt. Der Befestigungsrahmen ist aus einem dämpfenden Legierungsmaterial gefertigt.

Aus der CN 105 699 081 A ist eine Mess- und Prüfeinrichtung für eine elektrische Maschine bekannt, welche einen Lagerbock für eine Welle aufweist. Die Welle ist galvanisch von der elektrischen Maschine und vom Rahmen getrennt.

Die bekannten Einrichtungen weisen den Nachteil auf, dass auftretende Schwingungen und Kriechströme der Mess- und Prüfeinrichtung die Messungen nachteilig beeinflussen können werden.

Aufgabe der Erfindung ist es bei einer Mess- und Prüfeinrichtung der eingangs genannten Art eine Verfälschung der Messergebnisse zu vermeiden.

Erfindungsgemäß wird diese Aufgabe dadurch gelöst, dass der Lagerbock über zumindest eine Dämpfungsvorrichtung mit dem Zwischenrahmen verbunden ist, wobei zumindest eine erste Dämpfungsvorrichtung als elastischer Dämpfer und zumindest eine zweite Dämpfungsvorrichtung als Viskose- oder Sanddämpfer ausgebildet ist.

Auf diese Weise wird eine schwingungstechnische und insbesondere auch eine galvanische Trennung der Prüfeinrichtung vom zu prüfendem Antrieb erreicht.

Zur Vermeidung von Verfälschungen der Messergebnisse durch Kriechströme ist es vorteilhaft, wenn der Lagerbock vom Zwischenrahmen galvanisch getrennt ist.

Vorzugsweise weist der Viskose- oder Sanddämpfer einen mit einem Dämpfungsmaterial gefüllten Behälter auf, wobei im Behälter ein relativ zum Behälter im Dämpfungsmaterial beweglicher Dämpfungskörper angeordnet ist.

Der Behälter ist vorteilhafter Weise fest mit dem Zwischenrahmen verbunden und kann in den Zwischenrahmen integriert oder im Zwischenrahmen angeordnet oder am Zwischenrahmen angeordnet sein.

Eine Ausführungsvariante der Erfindung sieht dabei vor, dass das Dämpfungsmaterial ein rieselfähiger Stoff, vorzugsweise Sand, oder eine viskose Flüssigkeit, beispielsweise Silikonöl, ist. Dies ermöglicht eine effektive schwingungsmäßige Entkoppelung. Unter einer viskosen Flüssigkeit wird eine zähe Flüssigkeit verstanden, die jeder Formänderung einen definierten Reibungswiderstand entgegensetzt.

In weiterer Ausführung der Erfindung ist vorgesehen, dass zumindest ein elastischer Dämpfer zumindest ein - vorzugsweise mit dem Lagerbock fest verbundenes - elastisches Dämpfungselement aufweist, welches in einer - vorzugsweise fest mit dem Zwischenrahmen verbundenen - Tasse gelagert ist, wobei das elastische Dämpfungselement und/oder die Tasse elektrisch isolierend ausgebildet ist. Alter nativ kann die Tasse auch fest mit dem Lagerbock und das elastische Dämpfungselement fest mit dem Zwischenrahmen verbunden sein. Durch den elastischen Dämpfer wird die Übertragung von Schwingungen in einer Normal zur Wellenachse der Zwischenlagerwelle wesentlich vermindert. Zusätzlich wird durch Verwendung von elektrisch nichtleitenden Materialien für das Dämpfungselement und/oder die Tasse eine galvanische Trennung zwischen dem Lagerbock und dem Zwischenrahmen erzielt.

Vorzugsweise weist der elastische Dämpfer zumindest zwei elastische Dämpfungselemente auf, welche - in Richtung der Wellenachse betrachtet - in einem Stützabstand voneinander angeordnet sind und die Zwischenwelle so abstützen, dass ein Schwerpunkt des Lagerbockes inklusive aller Anbauteile innerhalb des Stützabstandes liegt. Dadurch wird eine gleichmäßige Abstützung der Zwischenlagerwelle erreicht und es werden Biegemomente vermieden. Als Anbauteile werden hier alle an den Lagerbock angebauten Elemente, insbesondere die Testeinheit, betrachtet.

Die Zwischenlagerwelle des Lagerbockes kann im Rahmen der Erfindung über eine - vorzugsweise als Gleichlaufgelenkwelle ausgebildete - Verbindungswelle mit einem Dynamometer, einem Hochsetzgetriebe oder einer weiteren Zwischenlagerwelle eines weiteren Lagerbocks antriebsverbunden sein. Um eine elektrische Verfälschung der Messergebnisse durch Kriechströme zu vermeiden, ist es vorteilhaft, wenn die Zwischenlagerwelle vom Dynamometer, dem Hochsetzgetriebe oder der weiteren Zwischenlagerwelle durch einen elektrischen Isolator galvanisch getrennt ist. Der elektrische Isolator kann beispielsweise durch ein elektrisch nichtleitendes Verbindungsrohr oder einen elektrisch nichtleitenden Flansch gebildet sein. Weiters ist es zur Vermeidung einer Verfälschung der Messergebnisse vorteilhaft, wenn zwischen der Testeinheit und dem Zwischenlager zumindest eine akustische und/oder thermische Isolierung angeordnet ist.

Im Rahmen der Erfindung ist weiters vorgesehen, dass die Mess- und Prüfeinrichtung eine Kühleinrichtung mit einem ersten Kühlkreis aufweist, der über zumindest einen Wärmetauscher mit einem zweiten Kühlkreis der Testeinheit thermisch verbindbar ist, wobei vorzugsweise der erste Kühlkreis vom zweiten Kühlkreis elektrisch entkoppelt ist.

Eine besonders gute elektrische Entkoppelung des ersten Kühlkreises und des zweiten Kühlkreises lässt sich erreichen, wenn der erste Kühlkreis über einen ersten Wärmetauscher thermisch mit einem Zwischenkreis verbunden ist, dessen Kühlleitung von einem Kühlmedium durchströmt ist, wobei der Zwischenkreis über einen zweiten Wärmetauscher mit einem zweiten Kühlkreis der Testeinheit thermisch verbindbar ist, wobei vorzugsweise das Kühlmedium des Zwischenkreises durch ein elektrisch nicht leitendes Dielektrikum gebildet ist. Weiters ist es zum Erreichen einer galvanischen Trennung der Kühlkreise vorteilhaft, wenn zumindest ein Abschnitt der Kühlleitung des Zwischenkreises aus einem elektrisch nichtleitenden Material besteht

Durch die erfindungsgemäßen Maßnahmen wird eine deutlich verbesserte Analyse von Elektromotoren ermöglich.

Die Erfindung wird im Folgenden anhand der nicht einschränkenden Figuren näher erläutert. Darin zeigen:
- Fig. 1: eine erfindungsgemäße Mess- und Prüfeinrichtung in einer ersten Ausführungsvariante;
- Fig. 2: ein Detail dieser Mess- und Prüfeinrichtung;
- Fig. 3: eine erfindungsgemäße Mess- und Prüfeinrichtung in einer zweiten Ausführungsvariante;
- Fig. 4: eine schematische Darstellung der Mess- und Prüfeinrichtung;
- Fig. 5: die Mess- und Prüfeinrichtung in einer weiteren Detailansicht;
- Fig. 6: eine Zwischenwelle der Mess- und Prüfeinrichtung;
- Fig. 7: eine Steckverzahnung der Zwischenwelle;
- Fig. 8: einen Adapter der Mess- und Prüfeinrichtung;
- Fig. 9: eine weitere Detailansicht der Mess- und Prüfeinrichtung; und
- Fig. 10: schematisch eine Kühlkreisanordnung der Mess- und Prüfeinrichtung.

Die Mess- und Prüfeinrichtung 100 dient zur Durchführung von Tests- und Messungen an zumindest einer Testeinheit UUT (Unit Under Test), beispielsweise einer schnelllaufenden elektrischen Maschine.

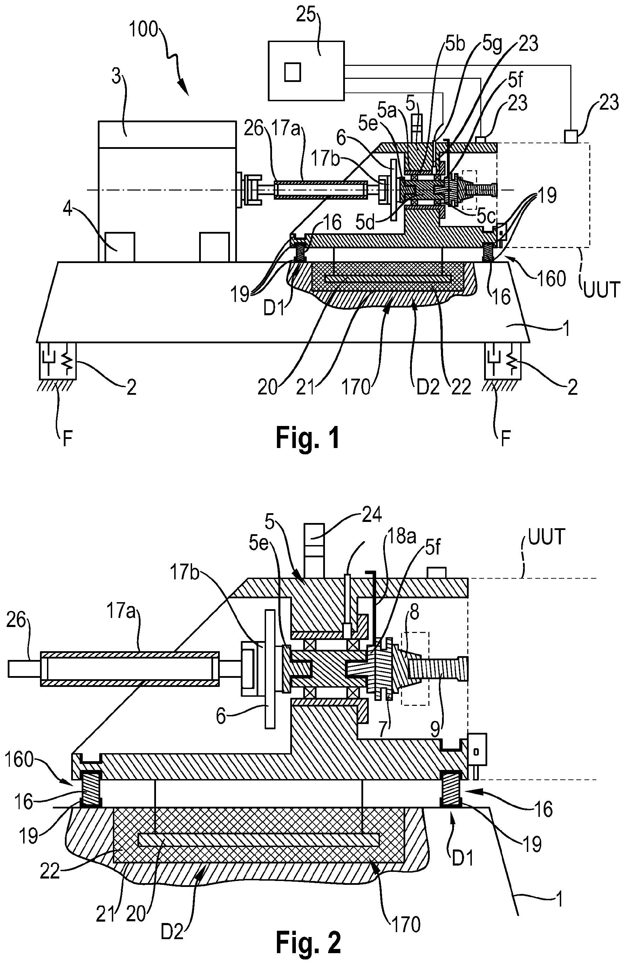

Die Mess- und Prüfeinrichtung 100 weist einen Zwischenrahmen 1 auf, der über beispielsweise durch Luftfedern gebildete Schwingungsisolierungselemente 2 mit einem Fundament F verbunden ist. Weiters weist die Mess- und Prüfeinrichtung 100 in der in Fig. 1 dargestellten Ausführungsvariante einen mit Bezugszeichen 3 bezeichneten Dynamometer und/oder ein Hochsetzgetriebe, das über eine hinreichend starre oder dämpfende Verbindung 4 am Zwischenrahmen 1 befestigt ist. Ein Hochsetzgetriebe mit Übersetzung ins Schnelle kann insbesondere bei einer Umrüstung von bestehenden Anlagen als Ersatz für einen Dynamometer verwendet werden.

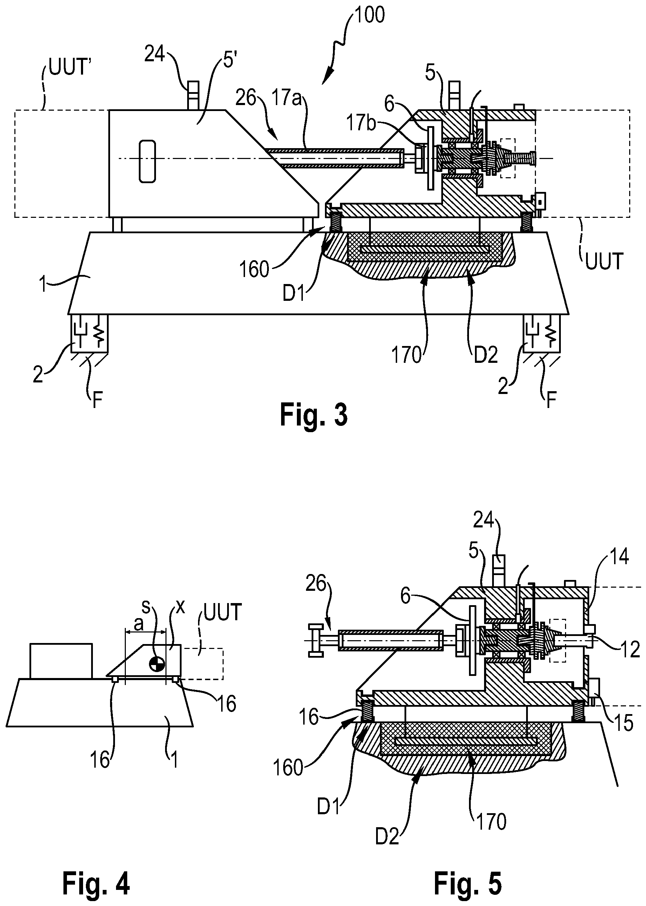

Des Weiteren besteht die Möglichkeit, für sogenannte "Back to back"-Tests anstelle des Dynamometers oder Hochsetzgetriebes 3 einen zweiten Lagerbock 5' zu verwenden, wie in Fig. 3 dargestellt ist. In dieser Konfiguration werden zwei Testeinheiten UUT, UUT' gleichzeitig getestet wobei der mögliche 4-Qudrantenbetrieb der Antriebe Voraussetzung ist da eine Testeinheit UUT generatorisch und die zweite Testeinheit UUT' motorisch betrieben wird.

Die Mess- und Prüfeinrichtung 100 weist zumindest einem Lagerbock 5 zur Lagerung einer Zwischenlagerwelle 5d auf. Der Lagerbock 5 ist über zumindest eine Dämpfungsvorrichtung D1, D2 flexibel mit dem Zwischenrahmen 1 verbunden.

In den dargestellten Ausführungsbeispielen sind zwei verschiedene Dämpfungsvorrichtungen D1, D2 vorgesehen. Eine erste Dämpfungsvorrichtung D1 ist als elastischer Dämpfer 160 und eine zweite Dämpfungsvorrichtung D2 als Viskoseoder Sanddämpfer 170 ausgebildet.

Der elastische Dämpfer 160 der ersten Dämpfungsvorrichtung D1 weist zumindest zwei elastische und dämpfende Elemente 16 auf, welche zwischen dem Lagerbock 5 und dem Zwischenrahmen 1 angeordnet sind. Der Stützabstand u zwischen zwei in Richtung der Achse 10 der Zwischenlagerwelle 5d beabstandete elastische Elemente 16 ist so bemessen, dass ein gemeinsamer Schwerpunkt S des Lagerbockes 5 inklusive aller Adapter und Anbauteile X sowie des Testelementes UUT innerhalb des Stützabstandes u zwischen den elastischen und dämpfenden Elementen 16 liegen muss (Fig. 4).

Der Lagerbock 5 besteht aus dem Zwischenlager 5a, das sich aus der Lagerpatrone 5b, den Lagern 5c, der Zwischenlagerwelle 5d und den tauschbaren Flanschen 5e, 5f sowie der Sensorik für Temperatur und Schwingungsüberwachung 5g zusammensetzt (Fig. 1).

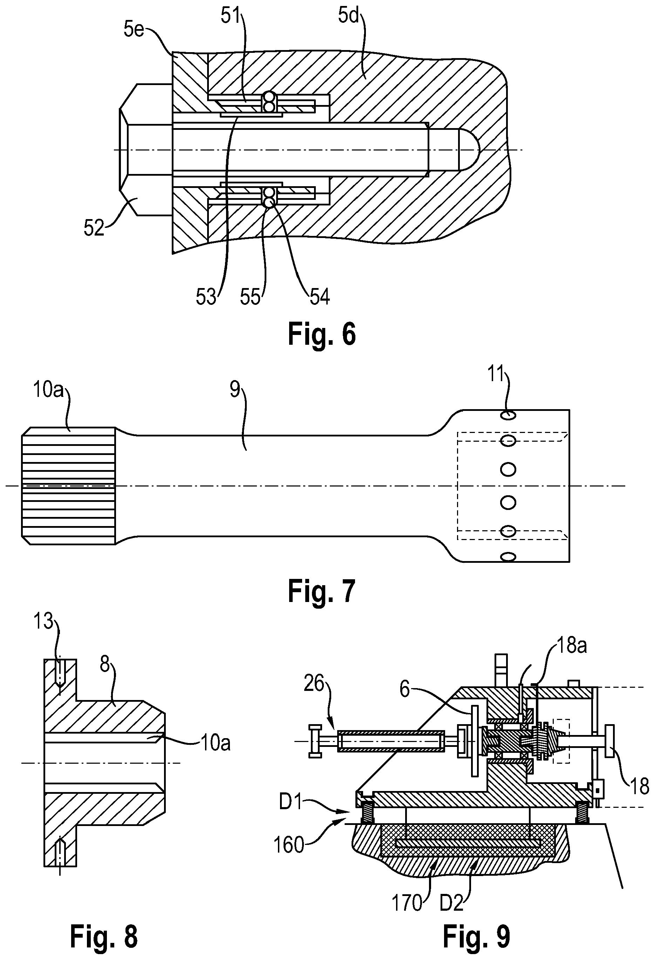

Wie in Fig. 6 an Hand des in Fig. 1 linken Flansches des Lagerbockes 5 gezeigt ist, ist der tauschbare Flansch 5e über sind über eine Steckverzahnung 51 formschlüssig mit der Zwischenlagerwelle 5d verbunden. Der Flansch 5e wird über eine Zentralschraube 52 axial gegen die Zwischenlagerwelle 5d vorgespannt wobei eine zusätzlich vorzugsweise verschraubt verbaute Hülse 53, die formschlüssig Kugeln 54 gegen eine Nut 55 presst, als Sicherung gegen Verlust dient. Analoges gilt auch für den auf der Seite der Testeinheit UUT angeordneten - aus den Fig. 1 und Fig. 2 ersichtlichen - rechten Flansch 5f.

Auf der Seite des Dynamometers 3 ist am Zwischenlager 5a eine Bremseinrichtung 6 befestigt, die es ermöglicht, den Antriebsstrang an in jeder beliebigen Position zu sperren, um das Losbrechmoment abhängig von der Lage des Rotors zum Stator der zu testenden elektrischen Maschine der Testeinheit UUT zu bestimmen.

Wie in Fig. 2 gezeigt ist, ist am testeinheitsseitigen Flansch 5f des Zwischenlagers 5 ein Messflansch 7 montiert, der beispielsweise mit einer Drehzahlerfassungseinrichtung ausgestattet ist, die es ermöglicht eine phasenrichtige Messung der mechanischen Leistung durchzuführen. Zusätzlich greift auf diesen Flansch 5f des Zwischenlagers 5 eine Blockiervorrichtung 18a an, die zum Sperren der Drehbewegung beim Kalibrieren des Messflansches 7 verwendet wird.

Der Adapter 8 für die zur Testeinheit UUT führenden Steckwelle 9 sitzt am Messflansch 7. Die Verbindung zu der Steckwelle 9 erfolgt über eine Steckverzahnung 10a mit definierter Einbaulage, um eine eindeutige Position zur Wahrung der Wuchtgüte zu ermöglichen. Der Adapter 8 ist so gestaltet, dass er neben der Steckwelle 9 zum Prüfling auch eine Kalibriereinrichtung 18b und ein Ausrichtewerkzeug 12 aufnehmen kann (siehe Fig. 2, Fig. 7, Fig. 8).

Zusätzlich sind am Adapterflansch 8 eine hinreichend große Anzahl von Bohrungen 13 zur Wuchtung des Aufbaus vorgesehen, die durch nicht weiter dargestellte Öffnungen im Lagerbock 5 einfach erreicht werden können (Fig. 8).

Die Steckwelle 9 zur Testeinheit UUT besitzt auf Seiten der Testeinheit UUT eine Aufnahme für eine Motorwelle der Testeinheit UUT. Zusätzlich sind Aufnahmen 11 für Wuchtgewichte vorgesehen, um gegebenenfalls die Laufruhe der Testeinheit UUT zu verbessern. Das Design des Aufbaus erlaubt es, durch die Schwingungsüberwachung 25 die Unwucht der Testeinheit UUT zu ermitteln.

Zum Ausrichten des in Fig. 5 angedeuteten Adapterflansches 14 zwischen der Prüfeinheit UUT und der Mess- und Prüfeinrichtung 100 sind sowohl am Lagerbock 5, als auch an einem optionalen Kühladapter für Klimakammern Einstellvorrichtungen 15 vorgesehen. Diese erlauben eine Ausrichtung mit dem Ausrichtewerkzeug 12 in Quer- und Hochrichtung.

Die Zwischenlagerwelle 5d des Zwischenlagers 5a ist mittels einer Gleichlaufgelenkwelle 26 mit dem Dynamometer 3 verbunden und durch einen elektrischen Isolator - beispielsweise durch ein elektrisch nichtleitendes Verbindungsrohr 17a oder einen elektrisch isolierenden Flansch 17b - vom Dynamometer 3 galvanisch getrennt.

Zur Isolierung des Lagerbocks 5 gegen den Zwischenrahmen 1 sind die Dämpfungselemente 16 in isolierende Tassen 19 so gefasst, dass kein elektrisch leitender Kontakt auftritt.

Um im Betriebsbereich auftretende Schwingformen des Lagerbocks 5 gegen den Zwischenrahmen 1 zu dämpfen, ist ein Viskose- oder Sanddämpfer 170 mit einem fest mit dem Lagerbock 5 verbundenen ein kielförmiger Dämpfungskörper 20 vorgesehen, der in einem Behälter 21 gefüllt mit hoch dämpfenden rieselfähigem oder flüssigem Dämpfungsmaterial 22, wie zum Beispiel Sand oder Silikonöl, beweglich gelagert ist.

Die Mess- und Prüfeinrichtung 100 ist mit Schwingungssensoren 23 für Linear- und Drehschwingungen ausgestattet, um mittels einer integrierten Datenerfassungsund Auswerteeinheit 25 eine detaillierte Analyse des Verhaltens sowohl der Messund Prüfeinrichtung 100, als auch der Prüfeinheit UUT ermöglichen.

Zur Überwachung des elektrischen Spannungszustandes an de Mess- und Prüfeinrichtung 100 sind beispielsweise an der höchsten Stelle des Lagerbockes 5, Warnleuchten 24 angebracht, die den Spannungszustand sowohl der Prüfeinheit UUT, als auch der Mess- und Prüfeinrichtung 100 anzeigen.

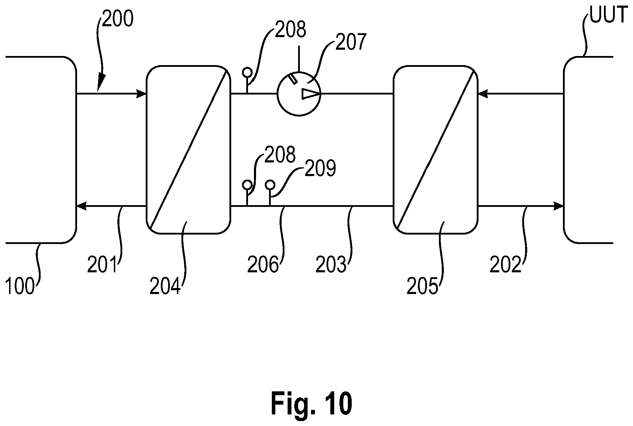

Zur Kühlung der Mess- und Prüfeinrichtung 100 kann diese eine Kühleinrichtung 200 mit einem ersten Kühlkreis 201 aufweisen. Wie in Fig. 10 dargestellt ist, können der erste Kühlkreis 201 der Mess- und Prüfeinrichtung 100 und ein zweiter Kühlkreis 202 der Testeinheit UUT voneinander elektrisch entkoppelt sein. Zur elektrischen Isolierung des ersten Kühlkreislaufes 201 der Mess- und Prüfeinrichtung 100 wird dieser mit einem Zwischenkreis 203 ausgestattet. Dieser Zwischenkreis 203 weist einen ersten Wärmetauscher 204 auf der Seite des ersten Kühlkreises 201 der Mess- und Prüfeinrichtung 100 und einen zweiten Wärmetauscher 205 auf der Seite des zweiten Kühlkreislaufs 202 der Testeinheit UUT auf. Diese beiden Wärmetauscher 204, 205 sind über Leitungen 206 des Zwischenkreises 205, welche aus elektrisch nichtleitendem Material bestehen, verbunden. Der Zwischenkreis 203 ist mit einem durch ein nichtleitendes Dielektrikum gebildetes Medium gefüllt, dass als Wärmeträger fungiert. Das Medium wird mit Hilfe einer Pumpe 207 gefördert. Die Vor- und Rücklauftemperaturen werden mit Thermoelementen 208 gemessen. Die Kontrolle des Systemdrucks erfolgt über einen Drucksensor 209.

Die erfindungsgemäße Mess- und Prüfeinrichtung 100 weist somit eine vollkommene elektrische und schwingungstechnische Trennung von der zu prüfenden Testeinheit UUT auf und erhöht damit die Aussagesicherheit der Versuche.

Zusammenfassend weist die Mess- und Prüfeinrichtung 100 folgende Merkmale auf:
- Die Testeinheit UUT ist so mit dem Lagerbock 5 verbunden, dass der Schwerpunkt S der beiden innerhalb des Abstandes der Dämpfungselemente liegt.
- Der Lagerbock 5 ist in einem Fluid oder in Sand als Dämpfungsmaterial 22 gelagert.
- Der Antriebsstrang zwischen der Testeinheit UUT und dem Dynamometer 3 überträgt keine Rückstellkräfte.
- Der Antriebsstrang zwischen Lagerbock 5 und Dynamometer 3 ist elektrisch isoliert.
- Die Auflage des Lagerbocks 5 am Zwischenrahmen 1 ist elektrisch isolierend und mechanisch dämpfend ausgeführt.
- Die Wellenverbindung des Antriebsstranges zwischen UUT und Dynamometer 3 weist hinreichend große Ausgleichsmöglichkeiten auf, um Relativbewegungen zwischen dem Lagerbock 5 und dem Dynamometer 3 zu kompensieren.
- Der Wellenflansch zur Testeinheit UUT ist so ausgeführt, dass zumindest auch eine Kalibriereinrichtung 18b oder ein Ausrichtewerkzeug 12 aufnehmen kann.
- Zwischen der Testeinheit UUT und dem Zwischenlager 5a ist eine akustische und/oder thermische Isolierung angebracht.
- Die mechanische Leistungsmessung sitzt hinreichend nahe an der Testeinheit UUT, um negative Einflüsse von Anbauteilen zu vermeiden.
- Das Zwischenlager 5a kann über eine außen liegende Blockiervorrichtung 18a gesperrt werden, um Losbrech- und Stillstandsmomente, sowie Ströme und Spannungen ermitteln zu können.
- Die Testeinheit UUT ist von der Mess- und Prüfeinrichtung 100 galvanisch getrennt, um eine Beeinflussung der elektrischen Leistungsmessung über Kriechströme zu vermeiden.
- Der Aufbau der Mess- und Prüfeinrichtung 100 verfügt über eine Sicherheitseinrichtung, beispielsweise eine Warnleuchte 24, die optisch den Ladungszustand der Testeinheit UUT und/oder der Mess- und Prüfeinrichtung 100 anzeigt.
- Die Mess- und Prüfeinrichtung 100 verfügt über eine Mess- Datenerfassungs- und Auswerteeinheit 25, die das Schwingungsverhalten der Testeinheit UUT prüft, sowie deren Wuchtzustand ausgibt.

## Patentansprüche

1. Mess- und Prüfeinrichtung (100) für eine Testeinheit (UUT), insbesondere für eine schnelldrehende elektrische Maschine, mit einem Zwischenrahmen (1) und zumindest einem Lagerbock (5) für eine Zwischenlagerwelle (5d), welche mit zumindest einer Testeinheit (UUT) antriebsverbindbar ist, wobei der Lagerbock (5) vom Zwischenrahmen (1) galvanisch getrennt ist, **dadurch gekennzeichnet, dass** der Lagerbock (5) über zumindest eine Dämpfungsvorrichtung (D1, D2) mit dem Zwischenrahmen (1) verbunden ist, wobei zumindest eine erste Dämpfungsvorrichtung (D1) als elastischer Dämpfer (160) und zumindest eine zweite Dämpfungsvorrichtung (D2) als Viskose- oder Sanddämpfer (170) ausgebildet ist.

2. Mess- und Prüfeinrichtung (100) nach Anspruch 1, **dadurch gekennzeichnet, dass** der Lagerbock (5) über die zumindest eine Dämpfungsvorrichtung (D1, D2) vom Zwischenrahmen (1) galvanisch getrennt ist.

3. Mess- und Prüfeinrichtung (100) nach Anspruch 1 oder 2, **dadurch gekennzeichnet, dass** der Viskose- oder Sanddämpfer (170) einen mit einem Dämpfungsmaterial (22) gefüllten Behälter (21) aufweist, wobei im Behälter (21) ein relativ zum Behälter (21) im Dämpfungsmaterial (22) beweglicher Dämpfungskörper (20) angeordnet ist.

4. Mess- und Prüfeinrichtung (100) nach Anspruch 3, **dadurch gekennzeichnet, dass** der Behälter (21) fest mit dem Zwischenrahmen (1) verbunden ist, wobei vorzugsweise der Behälter (21) in den Zwischenrahmen (1) integriert ist oder im Zwischenrahmen (1) angeordnet ist oder am Zwischenrahmen (1) angeordnet ist.

5. Mess- und Prüfeinrichtung (100) nach Anspruch 3 oder 4, **dadurch gekennzeichnet, dass** das Dämpfungsmaterial (22) ein rieselfähiger Stoff, vorzugsweise Sand, oder ein viskoses Fluid ist.

6. Mess- und Prüfeinrichtung (100) nach einem der Ansprüche 1 bis 5, **dadurch gekennzeichnet, dass** zumindest ein elastischer Dämpfer (160) zumindest ein - vorzugsweise mit dem Lagerbock (5) fest verbundenes - elastisches Dämpfungselement (16) aufweist, welches in einer - vorzugsweise fest mit dem Zwischenrahmen (1) verbundenen - Tasse (19) gelagert ist, wobei das elastische Dämpfungselement (16) und/oder die Tasse (19) elektrisch isolierend ausgebildet ist.

7. Mess- und Prüfeinrichtung (100) nach Anspruch 6, **dadurch gekennzeichnet, dass** der elastische Dämpfer (160) zumindest zwei elastische Dämpfungselemente (16) aufweist, welche - in Richtung der Wellenachse (10) der Zwischenlagerwelle (5d) betrachtet - in einem Stützabstand (u) voneinander die Zwischenlagerwelle (5d) so abstützen, dass ein Schwerpunkt (S) des Lagerbockes (5) - vorzugsweise inklusive aller Anbauteile - innerhalb des Stützabstandes (u) liegt.

8. Mess- und Prüfeinrichtung (100) nach einem der Ansprüche 1 bis 7, **dadurch gekennzeichnet, dass** die Zwischenlagerwelle (5d) des Lagerbockes (5) über eine - vorzugsweise als Gleichlaufgelenkwelle ausgebildete - Verbindungswelle (26) mit einem Dynamometer (3), einem Hochsetzgetriebe (3) oder einer weiteren Zwischenlagerwelle (5d') eines weiteren Lagerbocks (5') antriebsverbunden ist, wobei vorzugsweise die Zwischenlagerwelle (5d) vom Dynamometer (3), dem Hochsetzgetriebe oder der weiteren Zwischenlagerwelle (5d') durch einen elektrischen Isolator galvanisch getrennt ist.

9. Mess- und Prüfeinrichtung (100) nach Anspruch 9, **dadurch gekennzeichnet, dass** der zwischen der Zwischenlagerwelle (5d) und dem Dynamometer (3) angeordnete elektrische Isolator durch ein elektrisch nichtleitendes Verbindungsrohr (17a) oder einen elektrisch nichtleitenden Flansch (17b) gebildet ist.

10. Mess- und Prüfeinrichtung (100) nach einem der Ansprüche 1 bis 9, **dadurch gekennzeichnet, dass** zwischen der Testeinheit (UUT) und dem Zwischenlager (5a) zumindest eine akustische und/oder thermische Isolierung angeordnet ist.

11. Mess- und Prüfeinrichtung (100) nach einem der Ansprüche 1 bis 10, **dadurch gekennzeichnet, dass** die Mess- und Prüfeinrichtung (100) eine Kühleinrichtung (200) mit einem ersten Kühlkreis (201) aufweist, der über zumindest einen Wärmetauscher (204, 205) mit einem zweiten Kühlkreis (201) der Testeinheit (UUT) thermisch verbindbar ist, wobei vorzugsweise der erste Kühlkreis (201) vom zweiten Kühlkreis (202) elektrisch entkoppelt ist.

12. Mess- und Prüfeinrichtung (100) nach Anspruch 11, **dadurch gekennzeichnet, dass** der erste Kühlkreis (201) über einen ersten Wärmetauscher (204) thermisch mit einem Zwischenkreis (203) verbunden ist, dessen Kühlleitung (206) von einem Kühlmedium durchströmt ist, wobei der Zwischenkreis (203) über einen zweiten Wärmetauscher (205) mit einem zweiten Kühlkreis (201) der Testeinheit (UUT) thermisch verbindbar ist, wobei vorzugsweise das Kühlmedium des Zwischenkreises (203) durch ein elektrisch nicht leitendes Dielektrikum gebildet ist.

13. Mess- und Prüfeinrichtung (100) nach Anspruch 11 oder 12, **dadurch gekennzeichnet, dass** zumindest ein Abschnitt der Kühlleitung (206) des Zwischenkreises (203) aus einem elektrisch nichtleitenden Material besteht.

## Claims

1. Measuring and testing device (100) for a unit under test (UUT), in particular for a rapidly rotating electric machine, comprising an intermediate frame (1) and at least one bearing block (5) for an intermediate bearing shaft (5d) which can be drive-connected to at least one unit under test (UUT), with the bearing block (5) preferably being galvanically isolated from the intermediate frame (1), **characterised in that** the bearing block (5) is connected to the intermediate frame (1) by means of at least one damping device (D1, D2), wherein at least a first damping device (D1) is designed as an elastic damper (160) and at least a second damping device (D2) is designed as a viscous or sand damper (170).

2. Measuring and testing device (100) according to claim 1, **characterised in that** the bearing block (5) is galvanically isolated from the intermediate frame (1) via the at least one damping device (D1, D2).

3. Measuring and testing device (100) according to claim 1 or 2, **characterised in that** the viscous or sand damper (170) comprises a container (21) filled with a damping material (22), wherein a damping body (20) movable relative to the container (21) in the damping material (22) is arranged in the container (21).

4. Measuring and testing device (100) according to claim 3, **characterised in that** the container (21) is fixedly connected to the intermediate frame (1), wherein preferably the container (21) is integrated into the intermediate frame (1) or is arranged in the intermediate frame (1) or is arranged on the intermediate frame (1).

5. Measuring and testing device (100) according to claim 3 or 4, **characterised in that** the damping material (22) is a free-flowing substance, preferably sand, or a viscous fluid.

6. Measuring and testing device (100) according to one of claims 1 to 5, **characterised in that** at least one elastic damper (160) comprises at least one elastic damping element (16), preferably firmly connected to the bearing block (5), which is mounted in a cup (19) that is preferably firmly connected to the intermediate frame (1), wherein the elastic damping element (16) and/or the cup (19) is designed to be electrically insulating.

7. Measuring and testing device (100) according to claim 6, **characterised in that** the elastic damper (160) has at least two elastic damping elements (16) which, as viewed in the direction of the shaft axis (10) of the intermediate bearing shaft (5d), support the intermediate bearing shaft (5d) at a support distance (u) from one another in such a way that a center of gravity (S) of the bearing block (5), preferably including all add-on parts, lies within the support distance (u).

8. Measuring and testing device (100) according to one of claims 1 to 7, **characterised in that** the intermediate bearing shaft (5d) of the bearing block (5) is drive-connected via a connecting shaft (26), preferably designed as a constant velocity drive shaft, to a dynamometer (3), a step-up gear unit (3) or a further intermediate bearing shaft (5d') of a further bearing block (5'), wherein preferably the intermediate bearing shaft (5d) is galvanically isolated from the dynamometer (3), the step-up gear unit or the further intermediate bearing shaft (5d') by an electrical insulator.

9. Measuring and testing device (100) according to claim 8, **characterised in that** the electrical insulator arranged between the intermediate bearing shaft (5d) and the dynamometer (3) is formed by an electrically non-conductive connecting tube (17a) or an electrically non-conductive flange (17b).

10. Measuring and testing device (100) according to one of claims 1 to 9, **characterised in that** at least one acoustic and/or thermal insulation is arranged between the unit under test (UUT) and the intermediate bearing (5a).

11. Measuring and testing device (100) according to one of claims 1 to 10, **characterised in that** the measuring and testing device (100) has a cooling device (200) with a first cooling circuit (201), which can be thermally connected to a second cooling circuit (201) of the unit under test (UUT) via at least one heat exchanger (204, 205), wherein the first cooling circuit (201) is preferably electrically decoupled from the second cooling circuit (202).

12. Measuring and testing device (100) according to claim 11, **characterised in that** the first cooling circuit (201) is thermally connected via a first heat exchanger (204) to an intermediate circuit (203), the cooling line (206) of which has a cooling medium flowing through it, wherein the intermediate circuit (203) is thermally connectable via a second heat exchanger (205) to a second cooling circuit (201) of the unit under test (UUT), wherein the cooling medium of the intermediate circuit (203) is preferably formed by an electrically non-conductive dielectric.

13. Measuring and testing device (100) according to claim 11 or 12, **characterised in that** at least a section of the cooling line (206) of the intermediate circuit (203) consists of an electrically non-conductive material.

## Revendications

1. Installation de mesure et de contrôle (100) pour une unité de test (UUT) notamment pour une machine électrique à rotation rapide avec un châssis intermédiaire (1) et au moins une poupée (5) pour un arbre de palier intermédiaire (5d) qui peut être relié dans le sens de l'entraînement à au moins une unité de test (UUT), la poupée (5) étant séparée galvaniquement du châssis intermédiaire (1),
installation **caractérisée en ce que**
la poupée (5) est reliée au châssis intermédiaire (1) par au moins un dispositif amortisseur (D1, D2), au moins un premier dispositif d'amortisseur (D1) étant réalisé comme amortisseur élastique (160) et au moins un second dispositif amortisseur (D2) est réalisé comme amortisseur à viscose ou sable (170).

2. Installation de mesure et de contrôle (100) selon la revendication 1, **caractérisée en ce que**
la poupée (5) est séparée galvaniquement du châssis intermédiaire (1) par au moins un dispositif amortisseur (D1, D2).

3. Installation de mesure et de contrôle (100) selon la revendication 1 ou 2,
**caractérisée en ce que**
l'amortisseur à viscose ou sable (170) comporte un récipient (21) rempli d'un matériau amortisseur (22), un corps d'amortisseur (20) étant installé dans le récipient (21) de manière mobile par rapport au récipient (21) dans le matériau amortisseur (22).

4. Installation de mesure et de contrôle (100) selon la revendication 3,
**caractérisée en ce que**
le récipient (21) est relié solidairement au châssis intermédiaire (1), de préférence le récipient (21) est intégré dans le châssis intermédiaire (1) ou est monté dans le châssis intermédiaire (1) ou sur le châssis intermédiaire (1).

5. Installation de mesure et de contrôle (100) selon la revendication 3 ou 4,
**caractérisée en ce que**
le matériau amortisseur (22) est une matière susceptible de couler de préférence du sable ou un fluide visqueux.

6. Installation de mesure et de contrôle (100) selon l'une des revendications 1 à 5,
**caractérisée en ce que**
au moins un amortisseur élastique (160) comporte un élément amortisseur (16) élastique, relié solidairement de préférence à la poupée (5) et qui est logée dans une coupelle (19) reliée de préférence solidairement au châssis intermédiaire (1),
l'élément amortisseur élastique (16) et/ou la coupelle (19) étant électroisolant.

7. Installation de mesure et de contrôle (100) selon la revendication 6, **caractérisée en ce que**
l'amortisseur élastique (160) comporte au moins deux éléments amortisseurs élastiques (16) qui, considérés dans la direction de l'axe (10) de l'arbre de palier intermédiaire (5d), à la distance d'appui (u) l'un de l'autre soutiennent l'arbre de palier intermédiaire (5d) de façon que le centre de gravité (S) de la poupée (5),
- de préférence, y compris tous les composants, se situe à l'intérieur de la distance d'appui (u).

8. Installation de mesure et de contrôle (100) selon l'une des revendications 1 à 7,
**caractérisée en ce que**
l'arbre de palier intermédiaire (5d) de la poupée (5) est relié dans le sens de l'entraînement par un arbre de liaison (26) -de préférence réalisé comme arbre synchrone- est réalisé à un dynamomètre (3), une transmission multiplicatrice (3) ou un autre arbre de palier intermédiaire (5d') d'une autre poupée (5'), de préférence l'arbre de palier intermédiaire (5d) étant séparé galvaniquement par un isolateur électrique par rapport au dynamomètre (3), à la transmission multiplicatrice ou à l'autre arbre de palier intermédiaire (5d').

9. Installation de mesure et de contrôle (100) selon la revendication 8,
**caractérisée en ce que**
l'isolateur électrique installé entre l'arbre de palier intermédiaire (5d) et le dynamomètre (3) est formé par un tube de liaison (17a) non électroconducteur ou par une bride (17b) non électro-conductrice.

10. Installation de mesure et de contrôle (100) selon l'une des revendications 1 à 9,
**caractérisée par**
une isolation acoustique et/ou thermique entre l'unité de test (UUT) et le palier intermédiaire (5a).

11. Installation de mesure et de contrôle (100) selon l'une des revendications 1 à 10,
**caractérisée en ce que**
l'installation de mesure et de contrôle (100) comporte une installation de refroidissement (200) avec un premier circuit de refroidissement (201) relié par une liaison thermique par au moins un échangeur de chaleur (204, 205) à un second circuit de refroidissement (201) de l'unité de test (UUT) de préférence, le premier circuit de refroidissement (201) est découplé électriquement du second circuit de refroidissement (202).

12. Installation de mesure et de contrôle (100) selon la revendication 11,
**caractérisée en ce que**
le premier circuit de refroidissement (201) est relié par une liasse thermique, par un premier échangeur (204), à un circuit intermédiaire (203), dont la conduite de refroidissement (206) est traversée par un milieu de refroidissement, le circuit intermédiaire (203) étant relié par une liaison thermique, par un second échangeur de chaleur (205) à un second circuit de refroidissement (201) de l'unité de test (UUT) de préférence, le milieu de refroidissement du circuit intermédiaire (203) est constitué par un diélectrique non-électroconducteur.

13. Installation de mesure et de contrôle (100) selon la revendication 11 ou 12,
**caractérisée en ce que**
au moins un segment de la conduite de refroidissement (206) du circuit intermédiaire (203) est en une matière non électro-conductrice.
